# EUROPÄISCHE PATENTANMELDUNG

(11) **EP 3 118 353 A1**
(43) Veröffentlichungstag der Anmeldung: **18.01.2017**
(21) Anmeldenummer: 15176473.5
(22) Anmeldetag: 13.07.2015
(51) Int. Cl.: C25D 5/50, B21C 1/00, C25D 7/06, C25D 17/02, C23C 18/16, H01L 23/00

(54) **VERFAHREN ZUR HERSTELLUNG EINES DRAHTES AUS EINEM ERSTEN METALL MIT EINER MANTELSCHICHT AUS EINEM ZWEITEN METALL**

(71) Anmelder: Heraeus Deutschland GmbH & Co. KG, 63450 Hanau (DE)
(72) Erfinder: SCHARF, Jürgen, 63776 Mömbris (DE); BEHL, Christin, 63776 Mömbris (DE); KÄSS, Steffen, 63486 Bruchköbel (DE); THOMAS, Sven, 60439 Frankfurt (DE)
(74) Vertreter: Heraeus IP

(57) **Zusammenfassung**

Verfahren zur Beschichtung eines Drahtes aus einem Metall 1 ausgewählt aus der Gruppe bestehend aus Kupfer, Silber, Gold, Nickel sowie Legierungen eines dieser Metalle mit mindestens einem anderen Metall mit einer Mantelschicht aus einem von Metall 1 verschiedenen Metall 2 ausgewählt aus der Gruppe bestehend aus Nickel, Silber, Gold, Ruthenium, Platin, Palladium, Rhodium sowie Legierungen eines dieser Metalle mit mindestens einem anderen Metall, umfassend die Schritte:
(a) Bereitstellung eines Drahtes mit einer Querschnittsfläche im Bereich von 75 bis 200000 µm² aus einem Metall 1,
(b) Bereitstellung eines Behälters mit einer Einlassöffnung für den Draht, wobei der Umriss der Einlassöffnung dem des zu ummantelnden Drahtes entspricht oder einen bis zu 20 µm breiten wenigstens teilweise um den Drahtumriss umlaufenden Spalt bildet,
(c) Einführen des Drahtes in die Einlassöffnung,
(d) Einfüllen einer zum Aufbringen der Mantelschicht aus dem von Metall 1 verschiedenen Metall 2 geeigneten flüssigen Beschichtungszusammensetzung in den Behälter,
(e) gerades Hindurchführen des Drahtes durch die flüssige Beschichtungszusammensetzung und den Behälter und Verlassen des Behälters in beschichteter Form, und
(f1) Trocknen des in Schritt (e) beschichteten Drahtes oder
(f2) thermisches Behandeln des in Schritt (e) beschichteten Drahtes,

wobei
(i) es sich bei der flüssigen Beschichtungszusammensetzung um eine eine außenstromlose Applikation von Metall 2 auf ein Substrat aus dem Metall 1 erlaubende Zusammensetzung handelt oder
(ii) der Draht als Kathode geschaltet ist und es sich bei der flüssigen Beschichtungszusammensetzung um eine eine Elektroplattierung mit Metall 2 eines als Kathode geschalteten Substrates aus dem Metall 1 erlaubende Zusammensetzung handelt.

## Beschreibung

Die Erfindung betrifft ein Verfahren zur Herstellung eines Kern-Mantel-Drahtes durch Beschichtung eines Drahtes aus einem ersten Metall (= Metall 1) mit einer Mantelschicht aus einem zweiten Metall (= Metall 2).

Kern-Mantel-Bonddrähte mit einem Metallkern und einem Metallmantel aus einem anderen und im Allgemeinen edleren Metall als das des Kerns sind bekannt, beispielsweise aus US 2009/0188696 A1 oder EP 2 221 861 A1. Als Verfahren zur Herstellung der Mantelschicht wird unter anderem die elektrogalvanische Aufbringung (Elektroplattierung) erwähnt.

Beim erfindungsgemäßen Verfahren zur Herstellung eines Drahtes aus einem Metall 1 mit einer Mantelschicht aus einem Metall 2 handelt es sich um ein Beschichtungsverfahren. Genauer gesagt handelt es sich um ein Verfahren zur Beschichtung eines Drahtes aus einem Metall 1 ausgewählt aus der Gruppe bestehend aus Kupfer, Silber, Gold, Nickel sowie Legierungen eines dieser Metalle mit mindestens einem anderen Metall mit einer Mantelschicht aus einem von Metall 1 verschiedenen Metall 2 ausgewählt aus der Gruppe bestehend aus Nickel, Silber, Gold, Ruthenium, Platin, Palladium, Rhodium sowie Legierungen eines dieser Metalle mit mindestens einem anderen Metall, umfassend die Schritte:
(a) Bereitstellung eines Drahtes mit einer Querschnittsfläche im Bereich von 75 bis 200000 µm² aus einem Metall 1,
(b) Bereitstellung eines Behälters mit einer Einlassöffnung für den Draht, wobei der Umriss der Einlassöffnung dem des zu ummantelnden Drahtes entspricht oder einen bis zu 20 µm breiten wenigstens teilweise um den Drahtumriss umlaufenden Spalt bildet,
(c) Einführen des Drahtes in die Einlassöffnung,
(d) Einfüllen einer zum Aufbringen der Mantelschicht aus dem von Metall 1 verschiedenen Metall 2 geeigneten flüssigen Beschichtungszusammensetzung in den Behälter,
(e) gerades Hindurchführen des Drahtes durch die flüssige Beschichtungszusammensetzung und den Behälter und Verlassen des Behälters in beschichteter Form, und
(f1) Trocknen des in Schritt (e) beschichteten Drahtes oder
(f2) thermisches Behandeln des in Schritt (e) beschichteten Drahtes,
   wobei
(i) es sich bei der flüssigen Beschichtungszusammensetzung um eine eine außenstromlose Applikation von Metall 2 auf ein Substrat aus dem Metall 1 erlaubende Zusammensetzung handelt oder
(ii) der Draht als Kathode geschaltet ist und es sich bei der flüssigen Beschichtungszusammensetzung um eine eine Elektroplattierung mit Metall 2 eines als Kathode geschalteten Substrates aus dem Metall 1 erlaubende Zusammensetzung handelt.

In Schritt (a) des erfindungsgemäßen Verfahrens wird ein Draht mit einer Querschnittsfläche von 75 bis 200000 µm² aus einem Metall 1 bereitgestellt. Die Querschnittsfläche des Drahtes kann beispielsweise rechteckig, elliptisch oder rund, beispielsweise kreisförmig sein. Bevorzugt handelt es sich um Runddraht mit einem Durchmesser im Bereich von beispielsweise 10 bis 500 µm.

Bei dem Metall 1 handelt es sich um Kupfer, Silber, Gold, Nickel oder eine Legierung eines dieser Metalle mit mindestens einem anderen Metall. Im Falle reinen Kupfers, Silbers, Goldes oder Nickels sind Reinheitsgrade von 99,0 bis 99,99 Gew.-% gemeint, während Legierung hier bedeutet, dass das Basismetall Kupfer, Silber, Gold oder Nickel > 50 bis < 99 Gew.-% der Legierung ausmacht. Beispiele für mögliche Legierungsmetalle sind Kupfer, Silber, Gold, Nickel, Zink, Zinn, Antimon und Mangan.

Solcherlei Drähte sind dem Fachmann bekannt. Sie können insbesondere hergestellt werden durch Bereitstellung eines Metalls 1, d.h. als Metall mit gewünschtem Reinheitsgrad oder als Metalllegierung mit gewünschter Zusammensetzung, woraus dann in üblicher Weise ein Drahtvorläufer, beispielsweise ein runder Drahtvorläufer mit einem Durchmesser im Bereich von 3 bis 300 mm durch Gießen hergestellt werden kann. Ein solcher Drahtvorläufer kann anschließend üblichen Walz-, Drahtzieh- und/oder Glühschritten unterworfen werden, um letztlich den gemäß Schritt (a) bereitzustellenden Draht zu bilden.

Im Allgemeinen ist es zweckmäßig, den Draht mit sauberer metallischer Oberfläche bereitzustellen, beispielsweise von Hilfsstoffen und anderen Verunreinigungen befreit, z.B. entfettet und/oder von Oxid befreit. Methoden zur Erzeugung einer sauberen metallischen Oberfläche sind dem Fachmann bekannt und bedürfen keiner detaillierten Erläuterung, beispielhaft seien Beizverfahren, elektrolytische Reinigung und Abkochentfettung genannt.

Die Querschnittsfläche oder der Durchmesser des in Schritt (a) bereitgestellten Drahtes bzw. Runddrahtes kann dessen Endquerschnittsfläche bzw. Enddurchmesser sein. Dies ist insbesondere bei Drähten mit einer Querschnittsfläche oder Runddrähten mit einem Durchmesser jeweils am unteren Ende der vorstehend genannten Bereiche von 75 bis 200000 µm² bzw. 10 bis 500 µm der Fall, beispielsweise im Bereich von 75 bis 2000 µm² für die Drahtquerschnittsfläche bzw. von 10 bis 50 µm für den Runddrahtdurchmesser. Die Möglichkeit, die Mantelschicht aus dem Metall 2 auf einen schon Endquerschnittsfläche oder Enddurchmesser aufweisenden Draht bzw. Runddraht aus dem Metall 1 aufzubringen, stellt eine der Stärken des erfindungsgemäßen Verfahrens dar, insbesondere in Hinsicht auf eine zumindest weitestgehende Vermeidung von Beschädigungen der äußeren Oberfläche der Mantelschicht. Ferner weisen die per EBSD (electron back-scattering diffraction) bzw. elektronenmikroskopisch sichtbar machbaren Körner der Mantelschicht bei dieser Ausführungsform keine Vorzugsrichtung auf, sondern bilden die Kornstruktur des unterhalb der Mantelschicht befindlichen Metalls 1 ab.

Bei der Durchführung des erfindungsgemäßen Verfahrens mit einem in Schritt (a) bereitgestellten Draht mit Endquerschnittsfläche bzw. Runddraht mit Enddurchmesser handelt es sich um bevorzugte Ausführungsformen.

Im Falle von Drähten mit einer Querschnittsfläche oder Runddrähten mit einem Durchmesser jeweils am oberen Ende der genannten Bereiche, beispielsweise im Bereich von 700 bis 200000 µm² für die Drahtquerschnittsfläche bzw. von 30 bis 500 µm für den Runddrahtdurchmesser, ist es möglich, eine Reduzierung auf eine geringere Endquerschnittsfläche bzw. einen geringeren Enddurchmesser und damit einhergehend eine Verlängerung des ummantelten Drahtes bzw. Runddrahtes nach Beendigung von Schritt (f1) bzw. (f2) durchzuführen, beispielsweise durch übliches Drahtziehen. In diesem Falle weisen die per EBSD bzw. elektronenmikroskopisch sichtbar machbaren Körner der Mantelschicht anders als im im vorhergehenden Absatz beschriebenen Fall eine in Drahtrichtung verlaufende Orientierung bzw. Vorzugsrichtung auf.

Üblicherweise wird der Draht in Schritt (a) in aufgespulter Form bereitgestellt.

In Schritt (b) des erfindungsgemäßen Verfahrens wird ein Behälter mit einer dem Umriss des in Schritt (a) bereitgestellten zu ummantelnden Drahtes entsprechenden oder einen bis zu 20 µm, bevorzugt bis zu 10 µm breiten wenigstens teilweise, bevorzugt vollständig um den Drahtumriss umlaufenden Spalt bildenden Einlassöffnung bereitgestellt. Ein teilweise um den Drahtumriss umlaufender Spalt bedeutet, dass der Draht den Rand der Einlassöffnung berührt, allerdings nicht mit seinem gesamten Umriss, während ein vollständig um den Drahtumriss umlaufender Spalt bedeutet, dass der Draht die Einlassöffnung nicht berührt. Im Fall der vollständigen Spaltbildung ist es bevorzugt, wenn der umlaufende Spalt möglichst gleichmäßig breit ist, entsprechend einer zentrierten Positionierung des zu ummantelnden Drahtes innerhalb der Einlassöffnung.

Im Zusammenwirken mit der chemisch/physikalischen Natur der zum Aufbringen der Mantelschicht aus dem von Metall 1 verschiedenen Metall 2 geeigneten flüssigen Beschichtungszusammensetzung bewirkt das genannte Spaltmaß eine hinreichende Abdichtung des Behälters, insbesondere während des Schrittes (e), d.h. ein Austreten der flüssigen Beschichtungszusammensetzung kann so verhindert werden.

Hinsichtlich der Materialauswahl des Behälters bestehen keine prinzipiellen Beschränkungen. Kunststoff hat sich als besonders zweckmäßig erwiesen. Der Behälter kann eine an sich beliebige Form haben; er muss lediglich die Verwirklichung des Schrittes (e) erlauben. Zweckmäßig ist ein zylindrischer Behälter mit Anordnung der Einlassöffnung insbesondere im Mittelpunkt der Zylindergrundfläche. Das den Rand der Einlassöffnung bildende Material ist zweckmäßigerweise ein hartes Material, insbesondere ein Material mit größerer Härte als der des Metalls 1. Beispielsweise kann das harte Material Diamant oder Rubin sein. Beispielsweise kann ein Diamant mit einem entsprechenden die Einlassöffnung des Behälters bildenden Loch verwendet werden. Es kann ferner zweckmäßig sein, wenn das Material, insbesondere das harte Material elektrisch nichtleitend ist (elektrische Leitfähigkeit <10⁻⁸ S/m); beispielsweise Diamant oder Rubin erfüllen beide Eigenschaften.

Es hat sich als besonders zweckmäßig erwiesen, einen Ziehstein (z.B. von BALLOFFET) als Mittel zur Ausstattung des Behälters mit der Einlassöffnung zu verwenden. Beispielsweise kann ein üblicher Ziehstein, wie er beim Drahtziehen verwendet wird, verwendet werden. Beispielsweise kann ein aus Titan oder Edelstahl bestehender Ziehstein mit darin eingefasstem, ein Loch mit entsprechendem Umriss aufweisendem Diamanten verwendet werden.

Der Behälter kann offen sein. In einer Ausführungsform hat der Behälter eine der Einlassöffnung gegenüber umriss-symmetrisch angeordnete und dabei zugleich mit der Einlassöffnung eine gemeinsame Rotationsachse aufweisende Auslassöffnung für den den Behälter verlassenden beschichteten Draht, d.h. für den im Zuge von Schritt (e) nach geradem Durchlaufen des Behälters denselben verlassenden beschichteten Draht; praktisch betrachtet bedeutet diese Anordnung, dass der Draht gerade, also ungebogen, ungekrümmt, ungeknickt und unverdrillt, und auf kürzestem Wege von der Einlassöffnung zur Auslassöffnung durch den Behälter hindurchlaufen kann. Diese Anordnung von Einlassöffnung und Auslassöffnung gewährleistet weitestgehend, dass es weder vor noch nach der Beschichtung zu Berührungen und möglichen mechanischen Beschädigungen der Drahtoberfläche kommt.

Dabei kann der Umriss der Auslassöffnung dem Umriss des den Behälter verlassenden beschichteten Drahtes entsprechen oder einen bis zu 20 µm breiten wenigstens teilweise, bevorzugt vollständig darum umlaufenden Spalt bilden. Die Auslassöffnung kann mit den gleichen Mitteln wie die Einlassöffnung verwirklicht werden.

In Schritt (c) des erfindungsgemäßen Verfahrens wird der in Schritt (a) bereitgestellte Draht in die Einlassöffnung eingeführt, im Falle einer Einlassöffnung mit größerer Querschnittsfläche bzw. größerem Umriss als dem des Drahtes bevorzugt mittig. Mit der Einführung des Drahtes wird die Grundlage für die schon erwähnte hinreichende Abdichtung des Behälters geschaffen.

In Schritt (d) des erfindungsgemäßen Verfahrens wird eine zum Aufbringen der Mantelschicht aus dem von Metall 1 verschiedenen Metall 2 geeignete flüssige Beschichtungszusammensetzung in den Behälter eingefüllt. Es ist zweckmäßig, Schritt (d) nach Schritt (c) auszuführen.

Im Falle der Ausführungsform (i) des erfindungsgemäßen Verfahrens handelt es sich bei der flüssigen Beschichtungszusammensetzung um eine eine außenstromlose Applikation von Metall 2 auf ein Substrat oder einen Draht aus dem Metall 1 erlaubende Zusammensetzung. Beispiele für solche Zusammensetzungen mit Metall 2 = Palladium bzw. Gold sind Palluna® IP1 von Umicore bzw. SLOTOGOLD 10 von Schlötter.

Im Falle der bevorzugten Ausführungsform (ii) des erfindungsgemäßen Verfahrens handelt es sich bei der flüssigen Beschichtungszusammensetzung um eine eine Elektroplattierung mit Metall 2 eines als Kathode geschalteten Substrates oder Drahtes aus dem Metall 1 erlaubende Zusammensetzung.

Insbesondere kann es sich dabei um eine wässrige, Metall 2 als gelöstes Salz oder gelöste Salze enthaltende Zusammensetzung handeln. Beispiele für solche Zusammensetzungen mit Metall 2 = Palladium sind Palluna® 458 und Palluna® ACF 800 von Umicore und Pallacor® HT von Atotech. Beispiele für solche Zusammensetzungen mit Metall 2 = Gold sind Aurocor® K 24 HF von Atotech und Auruna® 558 und Auruna® 559 von Umicore.

Die flüssige Beschichtungszusammensetzung wird in einer solchen Menge eingefüllt, dass eine erfolgreiche Durchführung von Schritt (e) gewährleistet werden kann. Dabei kann der Behälter teilweise oder vollständig gefüllt werden.

Es kann zweckmäßig sein, wenn der Behälter mit einer Einrichtung zur zumindest weitestgehenden Konstanthaltung des Füllvolumens und/oder der Zusammensetzung der flüssigen Beschichtungszusammensetzung ausgestattet ist, so dass der Verbrauch oder Austrag an flüssiger Beschichtungszusammensetzung bzw. von Komponenten derselben während des Schritts (e) im laufenden Betrieb ausgeglichen werden kann. Beispielsweise kann eine Einrichtung zur Kreislaufführung der flüssigen Beschichtungszusammensetzung und/oder eine Einrichtung zur Nachdosierung der flüssigen Beschichtungszusammensetzung oder von während Schritt (e) ausgetragener Komponenten derselben verwendet werden.

In Schritt (e) des erfindungsgemäßen Verfahrens wird der in Schritt (c) in die Einlassöffnung eingeführte Draht gerade, d.h. ungebogen, ungekrümmt, ungeknickt und unverdrillt durch den Behälter und damit auch durch die in Schritt (d) in den Behälter eingefüllte flüssige Beschichtungszusammensetzung hindurchgeführt. Nach Durchlaufen der flüssigen Beschichtungszusammensetzung verlässt der Draht den Behälter gerade und in beschichteter Form. Im Falle eines Behälters mit einer gegenüber dessen Einlassöffnung umriss-symmetrisch angeordneten und dabei zugleich mit der Einlassöffnung eine gemeinsame Rotationsachse aufweisenden Auslassöffnung verlässt der beschichtete Draht den Behälter durch letztere.

Die Kontaktzeit des durchlaufenden Drahtes oder, genauer gesagt, jedes Draht-Inkrementes in der flüssigen Beschichtungszusammensetzung liegt im Bereich von beispielsweise 0,005 bis 50 Sekunden, insbesondere 0,01 bis 10 oder 0,02 bis 5 Sekunden und ergibt sich aus der Geschwindigkeit, mit der der Draht durch die flüssige Beschichtungszusammensetzung hindurchgeführt wird, und aus der Strecke, die der Draht bzw. jedes Draht-Inkrement in der flüssigen Beschichtungszusammensetzung durchläuft. Bei vertikaler Ausrichtung des durch die flüssige Beschichtungszusammensetzung hindurchgeführten Drahtes entspricht die Strecke, die jedes Draht-Inkrement in der flüssigen Beschichtungszusammensetzung durchläuft, der Füllhöhe oder Flüssigkeitssäule der flüssigen Beschichtungszusammensetzung im Behälter.

Der Antrieb des Drahtes zwecks Hindurchführung durch die flüssige Beschichtungszusammensetzung geschieht mittels üblicher Umlenkrollen- und Spulensysteme. Die Drahtgeschwindigkeit oder, genauer gesagt, die Geschwindigkeit, mit der der Draht befördert wird, liegt dabei im Bereich von beispielsweise 0,5 bis 200 m/min, insbesondere 5 bis 150 m/min oder 10 bis 100 m/min. Die Ausrichtung des Behälters bzw. des durch diesen und die darin befindliche flüssige Beschichtungszusammensetzung gerade hindurchgeführten Drahtes kann horizontal oder vertikal sein oder eine dazwischenliegende Orientierung annehmen. Bevorzugt ist eine vertikale Ausrichtung, insbesondere mit Bewegungsrichtung des Drahtes nach oben.

Im Falle der Ausführungsform (ii) des erfindungsgemäßen Verfahrens mit einer eine Elektroplattierung eines als Kathode geschalteten Substrates oder Drahtes aus dem Metall 1 mit Metall 2 erlaubenden flüssigen Beschichtungszusammensetzung kann der Draht beispielsweise zweckmäßig mittels einer als Kathode geschalteten, beispielsweise metallischen Kontaktrolle als Kathode geschaltet werden und so die Drahtbeschichtung ermöglichen. Um einen Kurzschluss auszuschliessen, ist das den Rand der Einlassöffnung bildende Material elektrisch nichtleitend oder nicht spannungsführend (elektrisch isoliert).

Dabei kann ein elektrisch leitfähiger Ring, der ein den Rand der Einlassöffnung bildendes, elektrisch nichtleitendes Material, beispielsweise Diamant oder Rubin, umschließt, als Gegenanode geschaltet sein; beispielsweise kommt als elektrisch leitfähiger Ring der äußere Metallrand eines Ziehsteins in Frage. Zusätzlich oder stattdessen können auch ein oder mehrere Hilfsanoden verwendet werden, beispielsweise kann eine in der flüssigen Beschichtungszusammensetzung und um den durchlaufenden Draht angeordnete und dabei beispielsweise als Gitter ausgebildete Hilfsanode aus beispielsweise Edelstahl oder plattiertem Titan eingesetzt werden. Bei der Elektroplattierung des durch die flüssige Beschichtungszusammensetzung hindurchgeführten Drahtes mit Metall 2 kann mit einer Gleichspannung im Bereich von beispielsweise 0,2 bis 20 V bei einer Stromstärke im Bereich von beispielsweise 0,001 bis 5 A, insbesondere 0,001 bis 1 A oder 0,001 bis 0,2 A gearbeitet werden. Die zur Anwendung kommenden Stromdichten können im Bereich von beispielsweise 0,01 bis 150 A/dm² liegen.

Die Schichtdicke der Mantelschicht aus dem Metall 2 liegt im Bereich von beispielsweise der Dicke einer Monolayer des Metalls 2 bis 5000 nm oder von beispielsweise 1 bis 5000 nm und kann nach Wunsch eingestellt werden.

Bei der Ausführungsform (i) des erfindungsgemäßen Verfahrens mit einer eine außenstromlose Applikation von Metall 2 auf dem Draht aus Metall 1 erlaubenden flüssigen Beschichtungszusammensetzung kann die Schichtdicke der Mantelschicht aus dem Metall 2 im Wesentlichen über folgende Parameter eingestellt werden: chemische Zusammensetzung der flüssigen Beschichtungszusammensetzung, Temperatur während Schritt (e), Kontaktzeit zwischen Draht und flüssiger Beschichtungszusammensetzung. Dabei lässt sich die Schichtdicke im Allgemeinen steigern mit höherer Konzentration der Metall 2 bildenden chemischen Komponenten in der flüssigen Beschichtungszusammensetzung, mit höherer Temperatur während Schritt (e) und mit längerer Kontaktzeit zwischen Draht und flüssiger Beschichtungszusammensetzung.

Bei der Ausführungsform (ii) des erfindungsgemäßen Verfahrens mit einer eine Elektroplattierung eines als Kathode geschalteten Substrates bzw. Drahtes aus dem Metall 1 mit Metall 2 erlaubenden flüssigen Beschichtungszusammensetzung kann die Schichtdicke der Mantelschicht aus dem Metall 2 im Wesentlichen über folgende Parameter eingestellt werden: chemische Zusammensetzung der flüssigen Beschichtungszusammensetzung, Kontaktzeit zwischen als Kathode geschaltetem Draht und flüssiger Beschichtungszusammensetzung, Stromdichte. Dabei lässt sich die Schichtdicke im Allgemeinen steigern mit höherer Konzentration des oder der Salze von Metall 2 in der flüssigen Beschichtungszusammensetzung, mit längerer Kontaktzeit zwischen als Kathode geschaltetem Draht und flüssiger Beschichtungszusammensetzung und mit höherer Stromdichte.

Gegebenenfalls kann ein Spülschritt zwischen Abschluss von Schritt (e) und Schritt (f1) bzw. (f2) stattfinden, beispielsweise in Form einer Tauch- oder Spritzspülung. Falls die in Schritt (e) verwendete flüssige Beschichtungszusammensetzung wässrig ist, bietet sich die Verwendung von Wasser als Spülmedium an, weitere Beispiele für Spülmedien sind Alkohol und Alkohol/Wasser-Mischungen. Im Falle einer in Schritt (e) verwendeten nichtwässrigen flüssigen Beschichtungszusammensetzung wird im Allgemeinen nicht gespült.

Das erfindungsgemäße Verfahren erfordert kein Zwischenaufspulen des Drahtes zwischen den Schritten (e) und (f1) bzw. (e) und (f2). Insofern handelt es sich bei der Durchführung des erfindungsgemäßen Verfahrens ohne Zwischenaufspulen des Drahtes zwischen den Schritten (e) und (f1) oder (f2) um eine bevorzugte Ausführungsform. Zusammen mit der schon erwähnten Möglichkeit, die Mantelschicht aus dem Metall 2 auf einen schon Endquerschnittsfläche aufweisenden Draht bzw. Enddurchmesser aufweisenden Runddraht aus dem Metall 1 aufzubringen, kann das erfindungsgemäße Verfahren auch aus Produktionssicht besonders effizient gestaltet werden.

Bei der Ausführungsform des Schritts (f1) wird der in Schritt (e) beschichtete Draht, d.h. der mit einer Beschichtung im Sinne einer Mantelschicht aus Metall 2 versehene Draht lediglich getrocknet.

Das Trocknen gemäß Schritt (f1) kann bei einer Temperatur oder Ofentemperatur im Bereich von beispielsweise 20 bis 150 °C stattfinden.

Die in der Beschreibung und den Ansprüchen im Zusammenhang mit den Schritten (f1) bzw. (f2) verwendeten Begriffe "Temperatur" oder "Ofentemperatur" bedeuten jeweils die Temperatur der betreffenden Atmosphäre.

Beim Trocknen wird der beschichtete Draht bzw. dessen Beschichtung von organischem Lösemittel und/oder Wasser befreit. Das Trocknen kann beispielsweise in einem Durchlaufofen, insbesondere in einem Rohrofen geschehen.

Bei Durchführung der Schritt (f1) aufweisenden Variante des erfindungsgemäßen Verfahrens mit einem in Schritt (a) bereitgestellten Endquerschnittsfläche aufweisenden Draht bzw. Enddurchmesser aufweisenden Runddraht kann die Bildung einer Diffusionszone zwischen den Kontaktflächen von Metall 1 und Metall 2 vermieden oder zumindest weitestgehend vermieden werden.

Bei der Ausführungsform des Schritts (f2) des erfindungsgemäßen Verfahrens wird der in Schritt (e) beschichtete Draht thermisch behandelt.

Das thermische Behandeln gemäß Schritt (f2) kann bei einer Temperatur oder Ofentemperatur im Bereich von beispielsweise 100 bis 800 °C stattfinden.

Unter thermischem Behandeln ist zu verstehen, dass der Draht eine Temperatur erreicht, bei der der Draht und/oder dessen Beschichtung nicht nur, falls notwendig, getrocknet, sondern auch wie nachstehend noch erläutert chemisch und/oder physikalisch verändert werden. Die thermische Behandlung kann beispielsweise in einem Durchlaufofen, insbesondere in einem Rohrofen geschehen.

Die Durchlaufzeit des zwecks Trocknens oder thermischen Behandelns einen Durchlaufofen durchlaufenden Drahtes oder, genauer gesagt, jedes Draht-Inkrementes liegt im Bereich von beispielsweise 0,001 bis 60 Sekunden, insbesondere 0,01 bis 10 Sekunden oder 0,02 bis 5 Sekunden und ergibt sich aus der Baulänge des Durchlaufofens und der Geschwindigkeit, mit der der Draht den Durchlaufofen passiert.

Schritt (f2) kann beispielsweise dann durchgeführt werden, wenn nicht nur eine Trocknung erwünscht ist, sondern zugleich ein Glühen des mit Metall 2 ummantelten Drahtes stattfinden soll. Dies kann beispielsweise dann der Fall sein, wenn die Ausbildung einer Diffusionszone zwischen dem Metall 1 des Drahtkerns und dem Metall 2 des Drahtmantels durch Diffusion von Metall 1 oder Bestandteilen des Metalls 1 in das Metall 2 und/oder eine Diffusion von Metall 2 oder Bestandteilen des Metalls 2 in das Metall 1 gewünscht ist. In diesem Fall liegt die Ofentemperatur beispielsweise im Bereich von 150 bis 800 °C. Schritt (f2) kann also beispielsweise dann in Frage kommen, wenn die Beschichtung durch Elektroplattierung eines als Kathode geschalteten Drahtes aus dem Metall 1 mit Metall 2 aus einer entsprechenden Beschichtungszusammensetzung erfolgt ist. Es kann dabei zweckmäßig sein mit einer inerten oder reduzierenden Ofenatmosphäre zu arbeiten.

Der nach Beendigung der Schritte (a) bis (f1) bzw. (a) bis (f2) erhaltene Kern-Mantel-Draht zeichnet sich aus durch eine sehr homogene, gleichmäßig dicke und von Spuren mechanischer Beschädigung freie oder zumindest im Wesentlichen freie Mantelschicht und ist besonders geeignet zur Verwendung als Bonddraht.

Falls der nach dem erfindungsgemäßen Verfahren hergestellte Kern-Mantel-Draht in Form des mit einer Mantelschicht aus dem Metall 2 versehenen Drahtes aus dem Metall 1 nicht direkt weiterverarbeitet oder nicht direkt zum Bonden verwendet wird, wird er im Allgemeinen in üblicher Art und Weise aufgespult und in dieser Form zum Weiterverarbeiter oder Verwender geliefert. Weiterverarbeitung bedeutet hier insbesondere Ziehen, Glühen, Walzen, Aufbringung einer oder mehrerer weiterer Metall-Mantelschichten aus dem gleichen oder einem anderen Metall vom Typ 1, aus dem gleichen oder einem anderen Metall vom Typ 2 oder aus von Metall 1 und Metall 2 verschiedenem Metall. Hierbei erschließt es sich für den Fachmann unmittelbar, dass die Aufbringung weiterer Metall-Mantelschichten insbesondere auch unter Anwendung der Prinzipien wie im erfindungsgemäßen Verfahren erfolgen kann.

### Beispiele

### Beispiel 1 (Herstellung eines Kupferkern-Palladiummantel-Drahtes):

Ein Runddraht aus 4N-Kupfer (99,99 Gew.-% Kupfer) mit einem Durchmesser von 20 µm wurde in einen Abspuler eingespannt und über eine als Kathode schaltbare Kontaktrolle geführt. Dabei wurde der Runddraht von unten durch eine im Boden eines vertikal angeordneten zylindrischen Kunststoffbehälters (Innendurchmesser 40 mm, Länge 140 mm) befindliche Einlassöffnung eingebracht und gerade durch den Behälter geführt. Die Einlassöffnung bestand aus einem üblichen Ziehstein mit eingefasstem Diamant mit einem einen Durchmesser von 25 µm aufweisenden Loch (von BALLOFFET). In dem Behälter befand sich ferner eine runde Hilfsanode aus plattiertem Titan. Nach Verlassen des Behälters wurde der Runddraht ganz analog durch einen zweiten baugleichen Spülbehälter geführt. Anschliessend durchlief der Runddraht einen 60 cm langen auf 130 °C temperierten Rohrofen und wurde an einer Spule in einem Aufspuler befestigt. Die Laufrichtung des Runddrahtes war von unten nach oben mit der Anordnungsreihenfolge von unten nach oben: Kontaktrolle, Behälter 1; Behälter 2, Rohrofen, Aufspuler. Der untere die Hilfsanode aufweisende Behälter 1 wurde gemäß Herstellervorgabe mit einer einen pH-Wert von 6,5 und einen Palladiumgehalt von 12 g/l aufweisenden Lösung von Palluna® ACF 800 bis zum Rand befüllt. Die Temperatur der Lösung wurde auf 60 °C eingestellt. Der darüber angeordnete Spülbehälter 2 wurde mit Wasser befüllt. Die Kontaktrolle wurde mit dem Minuspol einer Gleichstromquelle, die Hilfsanode im Behälter 1 mit dem Pluspol der Gleichstromquelle verbunden. Danach wurde der Aufspuler eingeschaltet und auf eine Drahtgeschwindigkeit von 15 m/min eingestellt. Die Gleichstromquelle wurde auf eine Stromstärke von 10 mA eingestellt.

Man erhielt einen mit einer 20 nm dicken gleichmäßigen Palladiummantelschicht versehenen Kupfer-Runddraht, der elektronenmikroskopisch betrachtet weitestgehend frei von Beschädigungen war (ohne Riefen, ohne Risse oder Aufbrüche in der Palladiumschicht) war.

### Beispiel 2 (Herstellung eines Kupferkern-Goldmantel-Drahtes):

Es wurde wie in Beispiel 1 gearbeitet mit dem Unterschied, dass in den Behälter 1 gemäß Herstellervorgabe eine einen pH-Wert von 7,5 und einen Goldgehalt von 15 g/l aufweisende Lösung von Auruna® 559 eingefüllt und der Beschichtungsvorgang bei 70°C und mit einer Stromstärke von 15 mA durchgeführt wurde.

Man erhielt einen mit einer 20 nm dicken gleichmäßigen Goldmantelschicht versehenen Kupfer-Runddraht, der elektronenmikroskopisch betrachtet weitestgehend frei von Beschädigungen war (ohne Riefen, ohne Risse oder Aufbrüche in der Palladiumschicht) war.

## Patentansprüche

1. Verfahren zur Beschichtung eines Drahtes aus einem Metall 1 ausgewählt aus der Gruppe bestehend aus Kupfer, Silber, Gold, Nickel sowie Legierungen eines dieser Metalle mit mindestens einem anderen Metall mit einer Mantelschicht aus einem von Metall 1 verschiedenen Metall 2 ausgewählt aus der Gruppe bestehend aus Nickel, Silber, Gold, Ruthenium, Platin, Palladium, Rhodium sowie Legierungen eines dieser Metalle mit mindestens einem anderen Metall, umfassend die Schritte:
(a) Bereitstellung eines Drahtes mit einer Querschnittsfläche im Bereich von 75 bis 200000 µm² aus einem Metall 1,
(b) Bereitstellung eines Behälters mit einer Einlassöffnung für den Draht, wobei der Umriss der Einlassöffnung dem des zu ummantelnden Drahtes entspricht oder einen bis zu 20 µm breiten wenigstens teilweise um den Drahtumriss umlaufenden Spalt bildet,
(c) Einführen des Drahtes in die Einlassöffnung,
(d) Einfüllen einer zum Aufbringen der Mantelschicht aus dem von Metall 1 verschiedenen Metall 2 geeigneten flüssigen Beschichtungszusammensetzung in den Behälter,
(e) gerades Hindurchführen des Drahtes durch die flüssige Beschichtungszusammensetzung und den Behälter und Verlassen des Behälters in beschichteter Form, und
(f1) Trocknen des in Schritt (e) beschichteten Drahtes oder
(f2) thermisches Behandeln des in Schritt (e) beschichteten Drahtes,
wobei
(i) es sich bei der flüssigen Beschichtungszusammensetzung um eine eine außenstromlose Applikation von Metall 2 auf ein Substrat aus dem Metall 1 erlaubende Zusammensetzung handelt oder
(ii) der Draht als Kathode geschaltet ist und es sich bei der flüssigen Beschichtungszusammensetzung um eine eine Elektroplattierung mit Metall 2 eines als Kathode geschalteten Substrates aus dem Metall 1 erlaubende Zusammensetzung handelt.

2. Verfahren nach Anspruch 1
ohne Zwischenaufspulen des Drahtes zwischen den Schritten (e) und (f1) oder (f2).

3. Verfahren nach Anspruch 1 oder 2,
wobei es sich bei dem in Schritt (a) bereitgestellten Draht um einen Runddraht mit einem Durchmesser im Bereich von 10 bis 500 µm handelt.

4. Verfahren nach Anspruch 3,
wobei der in Schritt (a) bereitgestellte Runddraht seinen Enddurchmesser aufweist.

5. Verfahren nach Anspruch 1 oder 2,
wobei der in Schritt (a) bereitgestellte Draht seine Endquerschnittsfläche aufweist.

6. Verfahren nach einem der vorhergehenden Ansprüche,
wobei das den Rand der Einlassöffnung bildende Material ein hartes Material mit größerer Härte als der des Metalls 1 ist.

7. Verfahren nach Anspruch 6,
wobei das harte Material Diamant oder Rubin ist.

8. Verfahren nach Anspruch 6,
wobei das harte Material elektrisch nichtleitend ist.

9. Verfahren nach einem der vorhergehenden Ansprüche,
wobei ein Ziehstein als Mittel zur Ausstattung des Behälters mit der Einlassöffnung verwendet wird.

10. Verfahren nach einem der vorhergehenden Ansprüche,
wobei der Behälter eine der Einlassöffnung gegenüber umriss-symmetrisch angeordnete und dabei zugleich mit der Einlassöffnung eine gemeinsame Rotationsachse aufweisende Auslassöffnung für den den Behälter verlassenden beschichteten Draht hat.

11. Verfahren nach einem der vorhergehenden Ansprüche,
wobei die Kontaktzeit jedes Draht-Inkrementes in der flüssigen Beschichtungszusammensetzung im Bereich von 0,005 bis 50 Sekunden liegt.

12. Verfahren nach einem der vorhergehenden Ansprüche,
wobei die Ausrichtung des Drahtes bei der Hindurchführung durch den Behälter und die darin befindliche flüssige Beschichtungszusammensetzung vertikal ist.

13. Verfahren nach Anspruch 12,
wobei die Bewegung des Drahtes nach oben gerichtet erfolgt.

14. Verfahren nach einem der vorhergehenden Ansprüche,
wobei die Schichtdicke der Mantelschicht aus dem Metall 2 im Bereich der Dicke einer Monolayer des Metalls 2 bis 5000 nm beträgt.

15. Verfahren nach einem der vorhergehenden Ansprüche,
wobei das Trocknen gemäß Schritt (f1) bei einer Temperatur im Bereich von 20 bis 150 °C stattfindet.

16. Verfahren nach einem der vorhergehenden Ansprüche,
wobei das thermische Behandeln gemäß Schritt (f2) bei einer Temperatur im Bereich von 100 bis 800 °C stattfindet.

17. Nach einem Verfahren eines der Ansprüche 1 bis 16 hergestellter Kern-Mantel-Draht.

18. Verwendung eines nach einem Verfahren eines der Ansprüche 1 bis 17 hergestellten Kern-Mantel-Drahtes als Bonddraht.
